# EUROPÄISCHE PATENTSCHRIFT

(11) **EP 1 762 542 B1**
(45) Veröffentlichungstag und Bekanntmachung des Hinweises auf die Patenterteilung: **03.04.2019**
(21) Anmeldenummer: 06119748.9
(22) Anmeldetag: 30.08.2006
(51) Int. Cl.: B81B 3/00

(54) **Mikromechanisches Sensorelement und Verfahren zu dessen Herstellung**
Micromechanical sensor element and its manufacturing method
Element d'un capteur microméchanique et son procédé de réalisation

(30) Priorität: 08.09.2005 DE 102005042664
(43) Veröffentlichungstag der Anmeldung: 14.03.2007
(73) Patentinhaber: ROBERT BOSCH GMBH, 70442 Stuttgart (DE)
(72) Erfinder: Reichenbach, Frank, 72827 Wannweil (DE); Schelling, Christoph, 72762 Reutlingen (DE); Leinenbach, Christina, 66806 Ensdorf (DE)

(56) Entgegenhaltungen:
- WO-A-03/045110
- DE-A1- 10 160 830
- US-A1- 2006 022 285

## Beschreibung

### Stand der Technik

Die Erfindung betrifft ein mikromechanisches Sensorelement mit mindestens einer Membran und mindestens einem Gegenelement, wobei zwischen der Membran und dem Gegenelement ein Hohlraum ausgebildet ist. Des Weiteren betrifft die Erfindung ein Verfahren zur Herstellung eines solchen Sensorelements.

Ein mikromechanisches Sensorelement der eingangs genannten Art, das vorzugsweise als Mikrofon eingesetzt werden soll, wird in der deutschen Offenlegungsschrift 101 60 830 beschrieben. Das bekannte Sensorelement ist in einem Schichtaufbau auf einem Substrat realisiert. In einer auf der Substratoberfläche aufgebrachten Epitaxieschicht ist ein als Gegenelektrode dienendes Gegenelement ausgebildet. Darüber befindet sich ein Hohlraum, der von einer beweglichen Membran überspannt wird. Das Substratmaterial unterhalb der Gegenelektrode wurde entfernt. Außerdem sind in der Gegenelektrode Durchgangsöffnungen ausgebildet, über die im Falle einer Deformation der Membran ein Druckausgleich zwischen dem Hohlraum und der Umgebung stattfindet. Die dafür erforderliche Be- bzw. Entlüftung des Hohlraums erfolgt also über die Rückseite des Sensorelements.

Die Herstellung des bekannten Sensorelements erfordert sowohl eine Prozessierung der Substratoberseite als auch eine Prozessierung der Substratrückseite, was relativ aufwändig ist. Außerdem kann die Größe der Durchgangsöffnungen in der Gegenelektrode bedingt durch diese zweiseitige Prozessierung, d.h. die Kombination von Oberflächenmikromechanik (OMM) und ulk-Mikromechanik, nicht unabhängig vom Abstand zwischen der Membran und der Gegenelektrode gewählt werden. Dadurch sind die Designmöglichkeiten für das bekannte Sensorelement eingeschränkt.

Aus der Schrift WO 03/045110 A1 ist ein Silizium-Mikrophon bekannt, bei der eine erste Membran mittels einer Federaufhängung über einer zweiten Membran in einem Halbleitersubstrat beweglich aufgehängt ist. Die Federaufhängung weist dabei ausgehend von der ersten Membran spiralförmige Verbindungen zu Trägern auf dem Halbleitersubstrat auf, um die erste Membran beweglich zu halten. Zusätzlich weist die erste Membran Abstandshalter auf, durch die ein Kontakt der ersten mit der zweiten Membran verhindert wird.

### Vorteile der Erfindung

Mit der vorliegenden Erfindung wird ein Sensorelement der eingangs genannten Art vorgeschlagen, bei dem eine gute Be- und Entlüftung des Hohlraums zwischen der Membran und dem Gegenelement gewährleistet ist, bei dessen Herstellung jedoch ausschließlich oberflächenmikromechanische Maßnahmen zum Einsatz kommen, so dass bei der Realisierung des erfindungsgemäßen Sensorelements eine größere Designfreiheit besteht.

Dies wird erfindungsgemäß dadurch erreicht, dass die Membran über Federelemente im Randbereich des Hohlraums festgelegt ist und dass zwischen den Federelementen Öffnungen zum Be- und Entlüften des Hohlraums ausgebildet sind.

Ausgehend davon, dass bei einer Deformation der Membran ein Druckausgleich zwischen dem Hohlraum und der Umgebung realisiert werden muss, ist erkannt worden, dass die dafür erforderliche Be- bzw. Entlüftung des Hohlraums nicht zwangsläufig über das starre Gegenelement zur Rückseite des Sensorelements hin erfolgen muss. Es ist vielmehr erkannt worden, dass eine Be- bzw. Entlüftung des Hohlraums auch membranseitig erfolgen kann, wenn die dafür erforderlichen Öffnungen in der Membranschicht entsprechend dimensioniert und angeordnet werden, um die Funktion der flexiblen Membran möglichst wenig zu beeinträchtigen. Erfindungsgemäß ist außerdem noch erkannt worden, dass die Funktionsfähigkeit und die Lebensdauer der Membran durch Öffnungen in der Membranschicht sogar verbessert bzw. gesteigert werden können, wenn die Öffnungen im Randbereich des Hohlraums angeordnet werden und so ausgelegt werden, dass zwischen den Öffnungen Federelemente als Aufhängung für die Membran verbleiben. Zum einen wird die Membran dadurch bezüglich intrinsischem Stress entkoppelt und zum anderen wird die Verformung der Membran durch die Federaufhängung auf den Randbereich konzentriert, wodurch sich die Linearität erhöht.

Das erfindungsgemäße Verfahren zur Herstellung eines solchen Sensorelements beschränkt sich, wie bereits erwähnt, auf eine Prozessierung der Substratoberfläche, bei der zunächst das Gegenelement ausgebildet wird. Im Bereich des Gegenelements wird dann mindestens eine Opferschicht aufgebracht, durch deren laterale Ausdehnung und Dicke die Abmessungen des zu erzeugenden Hohlraums definiert werden. Danach wird mindestens eine die Opferschicht überdeckende Membranschicht erzeugt und im Bereich über der Opferschicht strukturiert, wobei zumindest über dem Randbereich der Opferschicht Öffnungen erzeugt werden und durch die Öffnungen über dem Randbereich der Opferschicht Federelemente in der Membranschicht definiert werden. Die Membran und die Federelemente werden schließlich freigelegt, indem die Opferschicht durch die Öffnungen in der Membranschicht entfernt wird.
Grundsätzlich gibt es verschiedene Möglichkeiten für die Realisierung des erfindungsgemäßen Sensorelements und dementsprechend auch unterschiedliche Ausgestaltungen des erfindungsgemäßen Verfahrens.
Zur Verringerung der Dämpfung des Sensorelements können im Rahmen der Strukturierung der Membranschicht auch weitere Öffnungen erzeugt werden, durch die die Be- bzw. Entlüftung des Hohlraums unterstützt wird. Vorteilhafterweise sollten diese zusätzlichen Öffnungen im Randbereich der Membran angeordnet werden, um die Signalerfassung möglichst wenig zu beeinträchtigen.

Als ergänzende Maßnahme zur Minimierung der Dämpfung wird erfindungsgemäß vorgeschlagen, in der Oberfläche des Gegenelements Gräben auszubilden, die die Luft im Hohlraum in Richtung des Membranrandes, also in Richtung der Öffnungen zwischen den Federelementen, ableiten bzw. von dort zuleiten. Es ist deshalb besonders vorteilhaft, wenn mindestens ein Graben in Richtung des Membranrandes orientiert ist und/oder die Anzahl der Gräben in der Oberfläche des Gegenelements in Richtung des Membranrandes zunimmt. Aber auch ein im Bereich der Federelemente ausgebildeter umlaufender Graben in der Oberfläche des Gegenelements wirkt sich positiv auf die Dämpfungseigenschaften des Sensorelements aus.

Zur Realisierung der voranstehend beschriebenen Gräben wird das Gegenelement vor Aufbringen der Opferschicht entsprechend strukturiert. In diesem Zusammenhang erweist es sich als vorteilhaft, wenn die maximale Grabenbreite kleiner als die doppelte Dicke der Opferschicht gewählt wird, so dass die Gräben beim Aufbringen der Opferschicht vollständig aufgefüllt werden.

Es gibt aber auch Anwendungen, wie z.B. die Verwendung des erfindungsgemäßen Sensorelements als Mikrofon, für die es vorteilhaft ist, die Opferschicht nicht zu planarisieren, um die durch die Gräben im Gegenelement bedingte Topografie der Opferschicht gezielt auf die Membranschicht zu übertragen. Dadurch lässt sich nämlich einfach eine versteifte Membran erzeugen, wobei die Versteifungen entsprechend der Grabenstruktur des Gegenelements orientiert sind. Diese Maßnahme verhindert eine Verwölbung der Membran und konzentriert die Deformation der Membran auf den Randbereich und die Federaufhängung. Außerdem lässt sich dadurch auch die Anzahl der Aufhängepunkte reduzieren.
Die Gräben im Gegenelement des erfindungsgemäßen Sensorelements können lediglich oberflächlich ausgebildet sein, werden sich aber in der Regel über die gesamte Dicke des Gegenelements erstrecken. In diesem Fall kann die Be- bzw. Entlüftung des Hohlraums zwischen der Membran und dem Gegenelement zusätzlich auch über die Rückseite des Sensorelements erfolgen, wenn unterhalb des Gegenelements eine von der Rückseite ausgehende Kaverne ausgebildet ist. Mit Hilfe von Bulk-Mikromechanik lässt sich aber nicht nur einer Kaverne in der Substratrückseite unterhalb des Gegenelements erzeugen. Der Einsatz dieser Technologie ermöglicht auch die Realisierung von Gräben bzw. Durchgangsöffnungen im Gegenelement ausgehend von der Substratrückseite. In diesem Fall können die Abmessungen der Durchgangsöffnungen, insbesondere deren Breite bzw. Durchmesser, unabhängig von der Dicke der Opferschicht gewählt werden.

Bei einer besonders vorteilhaften Variante des erfindungsgemäßen Verfahrens werden das Gegenelement und die Membranschicht aus Polysilizium realisiert. Als Opferschichtmaterial wird Silizium-Germanium gewählt, das dann mittels eines Gasphasenätzschritts, insbesondere unter Einsatz von CIF3, wieder entfernt wird. Bei Verwendung dieser Schichtmaterialien kann nach dem Aufwachsen der Opferschicht ein Temperschritt durchgeführt werden, so dass Germanium in die unpassivierten Seitenwände der Gräben im Gegenelement diffundiert. Auf diese Weise können die Gräben beim Opferschichtätzen aufgeweitet werden, so dass sich ebenfalls Grabenbreiten erzielen lassen, die größer sind als das doppelte des Abstandes zwischen der Membran und dem Gegenelement.

### Zeichnungen

Wie bereits voranstehend ausführlich erörtert, gibt es verschiedene Möglichkeiten, die Lehre der vorliegenden Erfindung in vorteilhafter Weise auszugestalten und weiterzubilden. Dazu wird einerseits auf die den unabhängigen Patentansprüchen nachgeordneten Patentansprüche und andererseits auf die nachfolgende Beschreibung von Ausführungsbeispielen der Erfindung anhand der Zeichnungen verwiesen.
- Fig. 1: zeigt einen Querschnitt durch ein erstes erfindungsgemäßes Sensorelement,
- Fig. 2: zeigt einen Querschnitt durch ein zweites erfindungsgemäßes Sensorelement,
- Fig.3: zeigt eine Draufsicht auf das Gegenelement eines weiteren erfindungsgemäßen Sensorelements,
- Fig. 4: zeigt eine Draufsicht auf die Membran des in Fig. 3 dargestellten Sensorelements und
- Fig. 5a bis 5c: zeigen den Querschnitt durch den Schichtaufbau eines erfindungsgemäßen Sensorelements in verschiedenen Stadien der Herstellung.

### Beschreibung der Ausführungsbeispiele

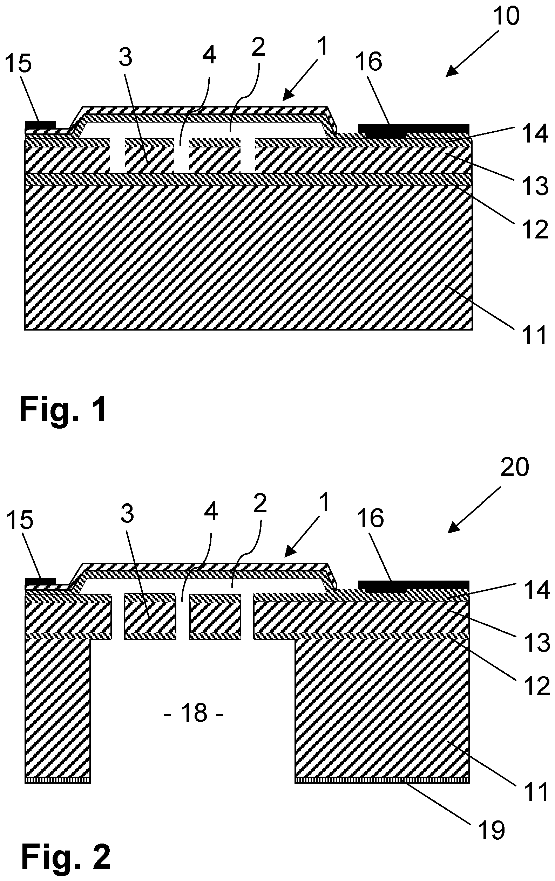

Das in Fig. 1 dargestellte mikromechanische Sensorelement 10 kann beispielsweise vorteilhaft als Mikrofon verwendet werden. Es umfasst eine Membran 1, die über den restlichen Chipbereich erhaben ist und einen Hohlraum 2 überspannt. Unter der Membran 1, den Boden des Hohlraums 2 bildend, befindet sich ein als Gegenelektrode dienendes Gegenelement 3.

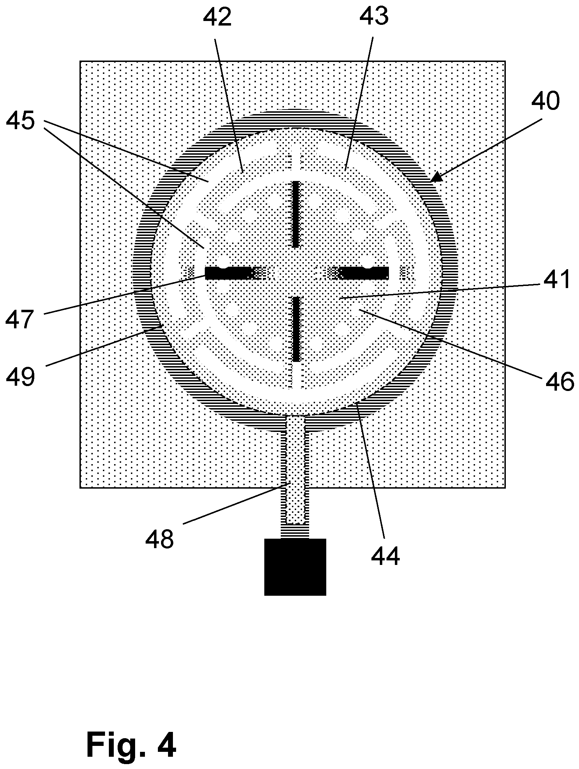

Erfindungsgemäß ist die Membran 1 über Federelemente im Randbereich des Hohlraums 2 festgelegt. Zwischen den Federelementen sind Öffnungen zum Be- und Entlüften des Hohlraums 2 ausgebildet, was insbesondere durch Fig. 4 veranschaulicht wird.

Die Gegenelektrode 3 ist in einer Epitaxieschicht 13 realisiert, die sich über einer ersten Passivierungsschicht 12 auf einem Substrat 11 befindet. Über der Epitaxieschicht 13 befindet sich eine zweite Passivierungsschicht 14. Die Membran 1 umfasst im hier dargestellten Ausführungsbeispiel zwei nicht näher bezeichnete Schichten, von denen wenigstens eine elektrisch leitfähig ist. Außerdem sind links und rechts der Membran 1 Leiterbahnen 15 und 16 zum Anschluss der Membran 1 einerseits und der Gegenelektrode 3 andererseits vorgesehen.

In der Gegenelektrode 3 sind Gräben 4 ausgebildet, die sich über die gesamte Dicke der Gegenelektrode 3 bzw. der zweiten Passivierschicht 14 und der Epitaxieschicht 13 erstrecken. Die Gräben 4 sind in Richtung des Membranrandes orientiert.

Das hier dargestellte Sensorelement 10 arbeitet als Druckgradientenmikrofon. Ankommende Schallwellen führen kurzfristig zu einem Druckunterschied zwischen der Vorderseite und der Rückseite der Membran 1, wodurch diese ausgelenkt wird. Durch die Auslenkung der Membran 1 wird die Luft im Hohlraum 2 verdrängt, was durch die Gräben 4 in der Gegenelektrode 3 begünstigt wird. Durch die Gräben 4 kann die Luft mit geringem Widerstand nach außen zum Membranrand strömen und dort durch die Öffnungen zwischen den Federelementen zur Vorderseite hin entweichen.

Vorteilhafterweise befindet sich die Gegenelektrode auf dem Substratpotenzial, während die Membran auf einer Betriebsspannung liegt. Dadurch können die parasitären Kapazitäten der Messung reduziert werden. Auch unterätzte Leiterbahnen tragen zur Reduzierung von Parasitärkapazitäten bei.

Der Schichtaufbau des in Fig. 2 dargestellten Sensorelements 20 entspricht im Wesentlichen dem des in Fig. 1 dargestellten Sensorelements 10. Auch die oberflächenmikromechanische Prozessierung und Strukturierung des Sensorelements 20 entspricht der des Sensorelements 10. Dementsprechend umfasst das Sensorelement 20 ebenfalls eine Membran 1, die einen Hohlraum 2 überspannt, der wiederum bodenseitig von einem Gegenelement 3 begrenzt wird. Die Membran 1 ist auch hier über Federelemente im Randbereich des Hohlraums 2 festgelegt, zwischen denen Öffnungen zum Be- und Entlüften des Hohlraums 2 ausgebildet sind.

Allerdings wurde das Gegenelement 3 des in Fig. 2 dargestellten Sensorelements 20 rückseitig freigelegt, indem das Substratmaterial in diesem Bereich entfernt wurde. Dazu wurde von der entsprechend maskierten Substratrückseite ausgehend eine Kaverne 18 erzeugt. Mit 19 ist die strukturierte Maskierschicht bezeichnet. Die Gräben 4 im Gegenelement 3 sind hier als Durchgangsöffnungen ausgebildet, die sich über die Passivierschicht 14, die Epitaxieschicht 13 und auch über die erste Passivierschicht 12 erstrecken, so dass der Hohlraum 2 über die Gräben bzw. Durchgangsöffnungen 4 mit der Rückseite des Sensorelements 20 kommuniziert. Die Be- bzw. Entlüftung des Hohlraums 2 im Falle einer Membranauslenkung wird hier also sowohl zur Vorderseite des Sensorelements 20 hin erfolgen, und zwar über die Öffnungen zwischen den Federelementen, als auch über die Gräben bzw. Durchgangsöffnungen 4 zur Rückseite des Sensorelements 20 hin.

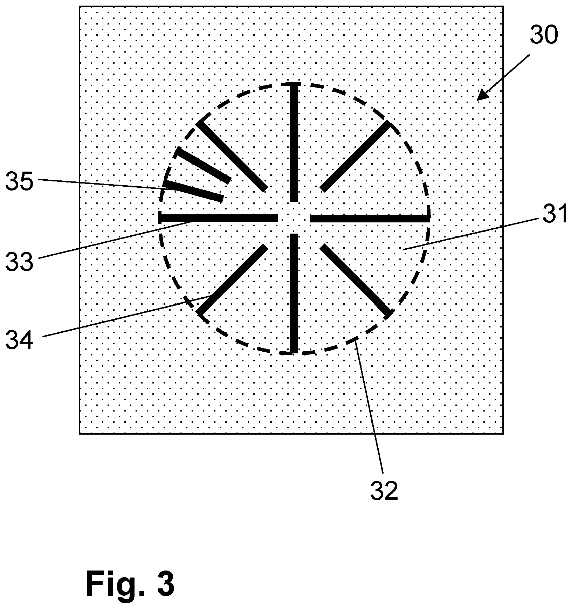

Die in Fig. 3 dargestellte Draufsicht zeigt die passivierte und strukturierte Epitaxieschicht 30 vor dem Aufbringen einer Opferschicht zur Herstellung eines erfindungsgemäßen Sensorelements. Die Membran und dementsprechend auch das Gegenelement 31, das in der Epitaxieschicht 30 ausgebildet wird, sollen hier eine radiale Topographie aufweisen. Durch die gestrichelte Kreislinie 32 wird die Kontur des Gegenelements 31 angedeutet. Im hier dargestellten Ausführungsbeispiel sind im Bereich des Gegenelements ausschließlich radial nach außen verlaufende Gräben 33, 34 und 35 ausgebildet. Die kreuzförmig angeordneten Gräben 33 erstrecken sich am weitesten in den Mittelbereich des Gegenelements 31. Mittig zwischen den Gräben 33 sind die Gräben 34 angeordnet, die sich immer noch weiter in den Mittelbereich des Gegenelements 31 erstrecken als die dazwischen angeordneten Gräben 35. Bei der hier dargestellten Auslegung und Anordnung der Gräben 33, 34 und 35 nimmt die Anzahl der Gräben in Richtung des Membranrandes zu.

In Fig. 4 ist eine strukturierte Membranschicht 40 dargestellt, die die in Fig. 3 dargestellte strukturierte und passivierte Epitaxieschicht 30 überlagern soll. Fig. 4 veranschaulicht die erfindungsgemäße Federaufhängung der kreisrunden Membran 41. Im hier dargestellten Ausführungsbeispiel umfasst die Federaufhängung insgesamt sechs Federelemente 42, 43, die paarweise von drei Ansatzstellen im Randbereich der Membran 41 ausgehen. Versetzt zu diesen sind die ebenfalls drei Ansatzstellen der Federelemente 42, 43 im Randbereich des Gegenelements 31 angeordnet, wobei die beiden von einer Ansatzstelle an der Membran 41 ausgehenden Federelemente 42, 43 hier an zwei benachbarten Ansatzstellen im Randbereich des Gegenelements 31 festgelegt sind.

Die gestrichelte Linie 44 begrenzt den Bereich der Membranschicht 40, der mit einer Opferschicht unterlegt wurde, also den Bereich des Hohlraums zwischen Gegenelement 31 und Membran 41. Im hier dargestellten Ausführungsbeispiel sind die Federelemente 42, 43 in der Membranschicht 40 ausgebildet und werden durch Entfernen der Opferschicht zusammen mit der Membran 41 freigelegt. Dementsprechend kommunizieren die Öffnungen 45 zwischen den Federelementen 42, 43 mit dem unter der Membran 41 befindlichen Hohlraum und ermöglichen so im Falle einer Deformation der Membran 41 einen Druckausgleich zwischen dem Hohlraum und der Umgebung.

Die Be- bzw. Entlüftung des Hohlraums wird im hier dargestellten Ausführungsbeispiel noch durch die weiteren im Randbereich der Membran 41 ausgebildeten Öffnungen 46 unterstützt.

Die Membran 41 wird über eine Zuleitung 48 elektrisch kontaktiert, die genau wie die Membran 41 und die Federelemente 42, 43 unterätzt ist. Der Opferschichtbereich, der den gesamten unterhöhlten Bereich des Sensorelements definiert, ist hier mit 49 bezeichnet.

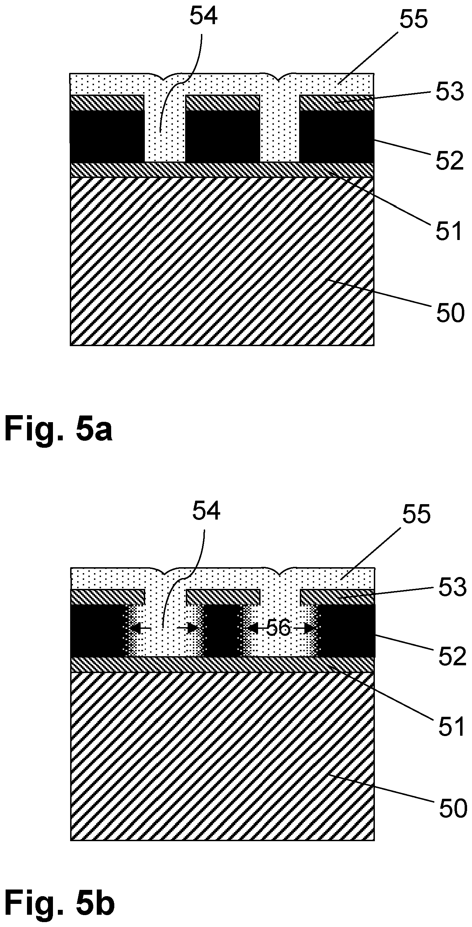

Die Membran 41 weist außerdem radial nach außen verlaufende Versteifungen 47 auf, die im Bereich über den Gräben 33 im Gegenelement 31 ausgebildet sind. Auf die Realisierung dieser Versteifungsstruktur wird nachfolgend in Verbindung mit den Fig. 5a bis 5c näher eingegangen, anhand derer ein Verfahren zur Herstellung eines erfindungsgemäßen Sensorelements näher erläutert wird.

In Fig. 5a ist ein Substrat 50 dargestellt, das beispielsweise durch einen Siliziumwafer gebildet werden kann. Auf das Substrat wurde zunächst eine erste Passivierungsschicht 51, z.B. eine SiO2-Schicht, aufgebracht. Darauf wurde eine Poly-Silizium-Schicht 52 aufgewachsen. Diese wurde planarisiert und dotiert, um ein Gegenelement, hier eine Gegenelektrode, zu realisieren. Anschließend wurde eine zweite Passivierungsschicht 53 aufgebracht, die als Diffusionsbarriere wirkt. Die zweite Passivierungsschicht 53 wurde zusammen mit der Poly-Silizium-Schicht 52 strukturiert, um Gräben 54 in der Gegenelektrode zu erzeugen. Fig. 5a zeigt den Schichtaufbau, nach dem Abscheiden einer Opferschicht 55, beispielsweise einer SiGe-Schicht, durch deren Dicke der Abstand h zwischen der Gegenelektrode und der noch zu erzeugenden Membran festgelegt wird. Da die Gräben 54 beim Abscheiden der Opferschicht 55 möglichst aufgefüllt werden sollen, sollte die maximale Grabenbreite w kleiner gewählt werden als die doppelte Dicke der Opferschicht 55. Fig. 5a verdeutlicht, dass sich die Topografie der strukturierten Poly-Silizium-Schicht 52 auf die Oberfläche der Opferschicht 55 übertragen hat.

Fig. 5b zeigt den in Fig. 5a dargestellten Schichtaufbau nach einem Temperschritt, bei dem Germanium aus der Opferschicht 55 in das Poly-Silizium der unpassivierten Seitenwände der Gräben 54 eindiffundiert ist, was durch die Pfeile 56 angedeutet wird.

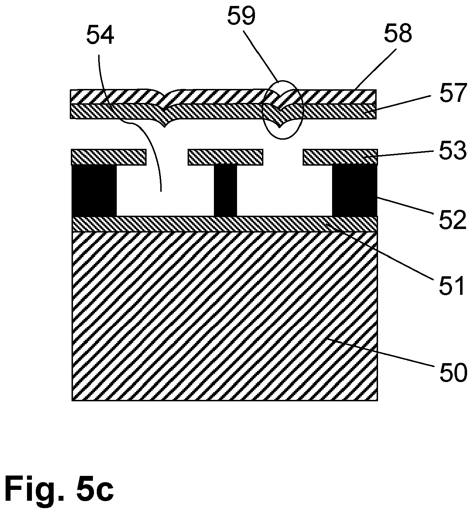

Zur Erzeugung der in Fig. 5c dargestellten Struktur wurde eine dritte Passivierungsschicht 57 auf der Opferschicht 55 abgeschieden, auf die dann eine Poly-Silizium-Schicht 58 als Membranschicht aufgebracht wurde. Da die Opferschicht 55 nicht planarisiert worden ist, hat sich die Topografie der Opferschicht 55 auch auf die Membranschicht 58 in Form von Versteifungen 59 übertragen, die entsprechend der Gräben 54 orientiert sind. Die Membranschicht 58 wurde dann mit Hilfe einer hier nicht dargestellten Maskierschicht strukturiert, wobei sowohl die Federaufhängung als auch ein Ätzzugang zum Entfernen der Opferschicht 55 erzeugt wurden.

Fig. 5c zeigt den Schichtaufbau nach dem Entfernen der Opferschicht 55, was beispielsweise in einem Gasphasenätzschritt mit CIF3 als Ätzmedium erfolgen kann. Dadurch werden sowohl die Membran als auch die Federaufhängung freigelegt. Aufgrund des in die Seitenwände der Gräben 54 eindiffundierten Germaniums können die Gräben 54 dabei zusätzlich aufgeweitet werden, so dass auch Grabenbreiten w realisiert werden können, die größer sind als der doppelte Abstand h zwischen der Membran und der Gegenelektrode.

## Patentansprüche

1. Mikromechanisches Sensorelement mit mindestens einer Membran (1; 41) und mindestens einem Gegenelement (3; 31),
wobei zwischen der Membran (1; 41) und dem Gegenelement (3; 31) ein Hohlraum (2) ausgebildet ist,
wobei die Membran (1; 41) über Federelemente (42, 43) im Randbereich des Hohlraums (2) festgelegt ist und zwischen den Federelementen (42, 43, 46) Öffnungen (45) zum Be- und Entlüften des Hohlraums (2) ausgebildet sind,
wobei in der Oberfläche des Gegenelements (3; 31) mindestens ein Graben (4, 33, 34, 35) ausgebildet ist, **dadurch gekennzeichnet dass**
die Membran (41) in Richtung des Membranrandes orientierte Versteifungen (47, 59) aufweist, welche entsprechend der Gräben orientiert sind.

2. Sensorelement nach Anspruch 1, **dadurch gekennzeichnet, dass** der mindestens eine Graben (33, 34, 35) in Richtung des Membranrandes orientiert ist.

3. Sensorelement nach einem der vorhergehenden Ansprüche, **dadurch gekennzeichnet dass** der mindestens eine Graben (33, 34, 35) im Gegenelement radial nach außen ausgebildet ist.

4. Sensorelement nach Anspruch 1, **dadurch gekennzeichnet dass** die Versteifungen (47, 59) auf der Membran (41) radial nach außen verlaufen.

5. Sensorelement nach einem der vorhergehenden Ansprüche, **dadurch gekennzeichnet, dass** die Anzahl der Gräben (33, 34, 35) in der Oberfläche des Gegenelements (31) in Richtung des Membranrandes zunimmt.

6. Sensorelement nach einem der vorhergehenden Ansprüche, **dadurch gekennzeichnet, dass** mindestens ein umlaufender Graben in der Oberfläche des Gegenelements im Bereich unterhalb der Federelemente ausgebildet ist.

7. Sensorelement nach einem der vorhergehenden Ansprüche, **dadurch gekennzeichnet, dass** sich der mindestens eine Graben (4) über die gesamte Dicke des Gegenelements (3) erstreckt.

8. Sensorelement nach einem der vorhergehenden Ansprüche, **dadurch gekennzeichnet, dass** der mindestens eine Graben (54) mindestens doppelt so breit ist wie der Abstand der Membran (58) vom Gegenelement (52).

9. Sensorelement nach Anspruch 8, **dadurch gekennzeichnet dass** auf dem Gegenelement (52) eine Passivierungsschicht (53) vorgesehen ist, welche entsprechend dem mindestens einen Graben (54) im Gegenelement (52) ebenfalls ein Graben aufweist, wobei vorgesehen ist, dass der Graben im Gegenelement (52) weiter aufgeweitet ist als in der Passivierungsschicht (53).

10. Sensorelement nach einem der vorhergehenden Ansprüche 1 bis 8, **dadurch gekennzeichnet, dass** unterhalb des Gegenelements (3) eine Kaverne (18) ausgebildet ist, so dass die Be- und Entlüftung des Hohlraums (2) zwischen der Membran (1) und dem Gegenelement (3) auch über den mindestens einen Graben (4) und die Kaverne (18) zur Rückseite des Sensorelements (20) hin erfolgt.

11. Sensorelement nach einem der vorhergehenden Ansprüche 1 bis 8 sowie 10, **dadurch gekennzeichnet, dass** die Membran (41) eine radiale Topographie aufweist und über mindestens drei Federelemente (42, 43) im Randbereich des Hohlraums befestigt ist.

12. Verwendung eines Sensorelements gemäß einem der Ansprüche 1 bis 10 als Mikrofon.

13. Verfahren zur Herstellung eines mikromechanischen Sensorelements mit mindestens einer Membran und mindestens einem Gegenelement, wobei zwischen der Membran und dem Gegenelement ein Hohlraum ausgebildet ist, insbesondere zur Herstellung eines Sensorelements gemäß einem der Ansprüche 1 bis 11, bei dem
- das mindestens eine Gegenelement auf einem Substrat (50) ausgebildet wird,
- im Bereich des Gegenelements mindestens eine Opferschicht (55) aufgebracht wird, durch deren laterale Ausdehnung und Dicke die Abmessungen des zu erzeugenden Hohlraums definiert werden,
- mindestens eine die Opferschicht (55) überdeckende Membranschicht (58) erzeugt wird,
- die Membranschicht (58) im Bereich über der Opferschicht (55) strukturiert wird, wobei zumindest über dem Randbereich der Opferschicht (55) Öffnungen erzeugt werden und durch die Öffnungen über dem Randbereich der Opferschicht (55) Federelemente in der Membranschicht (58) definiert werden, und
- die Membran und die Federelemente freigelegt werden, indem die Opferschicht (55) durch die Öffnungen in der Membranschicht (58) entfernt wird, und
- im Gegenelement mindestens ein Graben (4) ausgebildet wird,
**dadurch gekennzeichnet dass**
in der Membranschicht (58) in Richtung des Membranrandes orientierte Versteifungen (47, 59) erzeugt werden, welche entsprechend der Gräben orientiert sind.

14. Verfahren nach Anspruch 13, **dadurch gekennzeichnet, dass** in dem Gegenelement mindestens ein Graben erzeugt wird, wobei die maximale Grabenbreite kleiner als die doppelte Dicke der Opferschicht (55) gewählt wird.

15. Verfahren nach Anspruch 14, **dadurch gekennzeichnet, dass** von der Rückseite des Substrats (11) ausgehend, unterhalb des Gegenelements (3) eine Kaverne (18) ausgebildet wird, so dass die Be- und Entlüftung des Hohlraums (2) zwischen der Membran (1) und dem Gegenelement (3) auch über den mindestens einen Graben (4) und die Kaverne (18) zur Rückseite des Sensorelements (20) hin erfolgt.

16. Verfahren nach Anspruch 13, **dadurch gekennzeichnet, dass** von der Rückseite des Substrats (11) ausgehend, unterhalb des Gegenelements (3) eine Kaverne (18) ausgebildet wird, und dass von der Kaverne (18) ausgehend mindestens eine Durchgangsöffnung (4) in dem Gegenelement (3) erzeugt wird, wobei der Durchmesser bzw. die Breite der Durchgangsöffnung (4) unabhängig von der Dicke der Opferschicht (55) gewählt wird.

17. Verfahren nach einem der Ansprüche 13 bis 16, wobei das Gegenelement und die Membranschicht (58) aus Polysilizium realisiert werden und die Opferschicht (55) aus Silizium-Germanium realisiert wird und wobei die Opferschicht (55) mittels eines Gasphasenätzschritts, insbesondere unter Einsatz von ClF3, entfernt wird.

18. Verfahren nach Anspruch 17, **dadurch gekennzeichnet, dass** nach dem Erzeugen der Opferschicht (55) ein Temperschritt durchgeführt wird, so dass Germanium in die unpassivierten Seitenwände des mindestens einen Grabens diffundiert, so dass der Graben beim Entfernen der Opferschicht (55) aufgeweitet wird.

## Claims

1. Micromechanical sensor element comprising at least one membrane (1; 41) and at least one counter-element (3; 31),
wherein a hollow space (2) is formed between the membrane (1; 41) and the counter-element (3; 31), wherein the membrane (1; 41) is fixed by means of spring elements (42, 43) in the edge region of the hollow space (2) and openings (45) for ventilating and venting the hollow space (2) are formed between the spring elements (42, 43, 46),
wherein at least one trench (4, 33, 34, 35) is formed in the surface of the counter-element (3; 31),
**characterized in that**
the membrane (41) has stiffeners (47, 59) oriented in the direction of the membrane edge, said stiffeners being oriented in a manner corresponding to the trenches.

2. Sensor element according to Claim 1, **characterized in that** the at least one trench (33, 34, 35) is oriented in the direction of the membrane edge.

3. Sensor element according to either of the preceding claims, **characterized in that** the at least one trench (33, 34, 35) is formed radially outwardly in the counter-element.

4. Sensor element according to Claim 1, **characterized in that** the stiffeners (47, 59) extend radially outwardly on the membrane (41).

5. Sensor element according to any of the preceding claims, **characterized in that** the number of trenches (33, 34, 35) in the surface of the counter-element (31) increases in the direction of the membrane edge.

6. Sensor element according to any of the preceding claims, **characterized in that** at least one circumferential trench is formed in the surface of the counter-element in the region below the spring elements.

7. Sensor element according to any of the preceding claims, **characterized in that** the at least one trench (4) extends over the entire thickness of the counter-element (3).

8. Sensor element according to any of the preceding claims, **characterized in that** the at least one trench (54) has a width at least double the distance between the membrane (58) and the counter-element (52).

9. Sensor element according to Claim 8, **characterized in that** a passivation layer (53) is provided on the counter-element (52), said passivation layer likewise having a trench in a manner corresponding to the at least one trench (54) in the counter-element (52), wherein provision is made for the trench in the counter-element (52) to be widened further than in the passivation layer (53).

10. Sensor element according to any of the preceding Claims 1 to 8, **characterized in that** a cavity (18) is formed below the counter-element (3), such that the hollow space (2) between the membrane (1) and the counter-element (3) is also ventilated and vented via the at least one trench (4) and the cavity (18) towards the rear side of the sensor element (20).

11. Sensor element according to any of the preceding Claims 1 to 8 and 10, **characterized in that** the membrane (41) has a radial topography and is secured by means of at least three spring elements (42, 43) in the edge region of the hollow space.

12. Use of a sensor element according to any of Claims 1 to 10 as a microphone.

13. Method for producing a micromechanical sensor element comprising at least one membrane and at least one counter-element, wherein a hollow space is formed between the membrane and the counter-element, in particular for producing a sensor element according to any of Claims 1 to 11, wherein
- the at least one counter-element is formed on a substrate (50),
- at least one sacrificial layer (55) is applied in the region of the counter-element, the lateral extent and thickness of said at least one sacrificial layer defining the dimensions of the hollow space to be produced,
- at least one membrane layer (58) covering the sacrificial layer (55) is produced,
- the membrane layer (58) is structured in the region above the sacrificial layer (55), wherein openings are produced at least above the edge region of the sacrificial layer (55) and the openings above the edge region of the sacrificial layer (55) define spring elements in the membrane layer (58), and
- the membrane and the spring elements are exposed by the sacrificial layer (55) being removed through the openings in the membrane layer (58), and
- at least one trench (4) is formed in the counter-element,
**characterized in that**
stiffeners (47, 59) oriented in the direction of the membrane edge are produced in the membrane layer (58), said stiffeners being oriented in a manner corresponding to the trenches.

14. Method according to Claim 13, **characterized in that** at least one trench is produced in the counter-element, wherein the maximum trench width is chosen to be less than double the thickness of the sacrificial layer (55).

15. Method according to Claim 14, **characterized in that**, proceeding from the rear side of the substrate (11), a cavity (18) is formed below the counter-element (3), such that the hollow space (2) between the membrane (1) and the counter-element (3) is also ventilated and vented via the at least one trench (4) and the cavity (18) towards the rear side of the sensor element (20).

16. Method according to Claim 13, **characterized in that**, proceeding from the rear side of the substrate (11), a cavity (18) is formed below the counter-element (3), and **in that**, proceeding from the cavity (18), at least one through opening (4) is produced in the counter-element (3), wherein the diameter or the width of the through opening (4) is chosen independently of the thickness of the sacrificial layer (55).

17. Method according to any of Claims 13 to 16, wherein the counter-element and the membrane layer (58) are realized from polysilicon and the sacrificial layer (55) is realized from silicon-germanium, and wherein the sacrificial layer (55) is removed by means of a gas phase etching step, in particular using ClF3.

18. Method according to Claim 17, **characterized in that** after producing the sacrificial layer (55), a heat treatment step is carried out, such that germanium diffuses into the unpassivated sidewalls of the at least one trench, such that the trench is widened when the sacrificial layer (55) is removed.

## Revendications

1. Élément de détection micromécanique comprenant au moins une membrane (1 ; 41) et au moins un contre-élément (3 ; 31),
une cavité (2) étant formée entre la membrane (1 ; 41) et le contre-élément (3 ; 31),
la membrane (1 ; 41) étant fixée par des éléments à ressort (42, 43) dans la région de bord de la cavité (2) et des ouvertures (45) étant ménagées entre les éléments à ressort (42, 43, 46) pour aérer et désaérer la cavité (2),
au moins une tranchée (4, 33, 34, 35) étant formée dans la surface du contre-élément (3 ; 31),
**caractérisé en ce que**
la membrane (41) comporte des raidisseurs (47, 59) qui sont orientés en direction du bord de la membrane et qui sont orientés de manière à correspondre aux tranchées.

2. Élément de détection selon la revendication 1,
**caractérisé en ce que** l'au moins une tranchée (33, 34, 35) est orientée en direction du bord de la membrane.

3. Élément de détection selon l'une des revendications précédentes, **caractérisé en ce que** l'au moins une tranchée (33, 34, 35) est formée radialement vers l'extérieur dans le contre-élément.

4. Élément de détection selon la revendication 1,
**caractérisé en ce que** les raidisseurs (47, 59) s'étendent radialement vers l'extérieur sur la membrane (41) .

5. Élément de détection selon l'une des revendications précédentes, **caractérisé en ce que** le nombre de tranchées (33, 34, 35) dans la surface du contre-élément (31) augmente en direction du bord de la membrane.

6. Élément de détection selon l'une des revendications précédentes, **caractérisé en ce qu'**au moins une tranchée circulaire est formée à la surface du contre-élément dans la région située au-dessous des éléments à ressort.

7. Élément de détection selon l'une des revendications précédentes, **caractérisé en ce que** l'au moins une tranchée (4) s'étend sur toute l'épaisseur du contre-élément (3).

8. Élément de détection selon l'une des revendications précédentes, **caractérisé en ce que** la largeur de l'au moins une tranchée (54) est au moins deux fois supérieure à la distance de la membrane (58) au contre-élément (52).

9. Élément de détection selon la revendication 8,
**caractérisé en ce qu'**une couche de passivation (53) est prévue sur le contre-élément (52), laquelle comporte également une tranchée qui correspond à au moins une tranchée (54) du contre-élément (52), la tranchée dans le contre-élément (52) étant prévue pour s'évaser davantage que celle dans la couche de passivation (53).

10. Élément de détection selon l'une des revendications précédentes 1 à 8, **caractérisé en ce qu'**une caverne (18) est formée au-dessous du contre-élément (3) de manière à aérer et désaérer la cavité (2) située entre la membrane (1) et le contre-élément (3) également par l'au moins une tranchée (4) et la caverne (18) en direction du côté arrière de l'élément de détection (20) .

11. Élément de détection selon l'une des revendications précédentes 1 à 8 et 10, **caractérisé en ce que** la membrane (41) présente une topographie radiale et est fixée dans la région de bord de la cavité par au moins trois éléments ressorts (42, 43).

12. Utilisation d'un élément de détection selon l'une des revendications 1 à 10 comme microphone.

13. Procédé de fabrication d'un élément de détection micromécanique comportant au moins une membrane et au moins un contre-élément, une cavité est ménagée entre la membrane et le contre-élément, en particulier pour réaliser un élément de détection selon l'une des revendications 1 à 11, dans lequel
- l'au moins un contre-élément étant formé sur un substrat (50),
- au moins une couche sacrificielle (55) est appliquée dans la région du contre-élément, dont l'étendue latérale et l'épaisseur définissent les dimensions de la cavité à générer,
- au moins une couche de membrane (58) est générée qui recouvre la couche sacrificielle (55),
- la couche de membrane (58) est structurée dans la région située au-dessus de la couche sacrificielle (55), des ouvertures étant ménagées au moins au-dessus de la région de bord de la couche sacrificielle (55) et des éléments à ressort étant définis situés dans la couche de membrane (58) par les ouvertures ménagées au-dessus de la région de bord de la couche sacrificielle (55), et
- la membrane et les éléments à ressort sont exposés en raison du fait que la couche sacrificielle (55) est retirée par les ouvertures ménagées dans la couche de membrane (58), et
- au moins une tranchée (4) est formée dans le contre-élément,
**caractérisé en ce que**
des raidisseurs (47, 59) orientés en direction du bord de la membrane sont réalisés dans la couche de membrane (58), lesquels sont orientés de manière à correspondre aux tranchées.

14. Procédé selon la revendication 13, **caractérisé en ce qu'**au moins une tranchée est formée dans le contre-élément, la largeur maximale de la tranchée étant choisie pour être inférieure à deux fois l'épaisseur de la couche sacrificielle (55).

15. Procédé selon la revendication 14, **caractérisé en ce qu'**une caverne (18) est formée au-dessous du contre-élément (3) à partir du côté arrière du substrat (11) de sorte que la cavité (2) formée entre la membrane (1) et le contre-élément (3) est aérée et désaérée également par l'au moins une tranchée (4) et la caverne (18) en direction du côté arrière de l'élément de détection (20).

16. Procédé selon la revendication 13, **caractérisé en ce qu'**une caverne (18) est formée au-dessous du contre-élément (3) à partir du côté arrière du substrat (11) et **en ce qu'**au moins une ouverture de passage (4) est ménagée dans le contre-élément (3) à partir de la caverne (18, le diamètre ou la largeur de l'ouverture de passage (4) étant choisi(e) indépendamment de l'épaisseur de la couche sacrificielle (55).

17. Procédé selon l'une des revendications 13 à 16, le contre-élément et la couche de membrane (58) étant en polysilicium et la couche sacrificielle (55) étant en silicium-germanium et la couche sacrificielle (55) étant retirée dans une étape de décapage en phase gazeuse, notamment à l'aide de ClF3.

18. Procédé selon la revendication 17, **caractérisé en ce qu'**une étape de recuit est effectuée après la formation de la couche sacrificielle (55) de sorte que le germanium se diffuse dans les parois latérales non passivées de l'au moins une tranchée de manière à élargir la tranchée lorsque la couche sacrificielle (55) est retirée.
